# EUROPEAN PATENT SPECIFICATION

(11) **EP 4 356 441 B1**
(45) Date of publication and mention of the grant of the patent: **06.08.2025**
(21) Application number: 22737769.4
(22) Date of filing: 17.06.2022
(51) Int. Cl.: H10N 70/00, H10N 70/20

(54) **ELECTRONIC TRANSISTORS**
ELEKTRONISCHE TRANSISTOREN
TRANSISTORS ÉLECTRONIQUES

(30) Priority: 18.06.2021 EP 21382543
(43) Date of publication of application: 24.04.2024
(73) Proprietor: Fundació Institut de Recerca en Energia de Catalunya, 08930 Sant Adrià del Besòs (ES); Institució Catalana de Recerca i Estudis Avançats, 08010 Barcelona (ES)
(72) Inventor: TARANCÓN RUBIO, Albert, 08031 BARCELONA (ES); CHIABRERA, Francesco, 16011 ARENZANO (IT); GARBAYO SENOSIAIN, Iñigo, 31008 PAMPLONA (ES); ALAYO BUENO, Nerea, 48013 BILBAO (ES); MORATA GARCÍA, Alex, 08930 ST. ADRIÀ DE BESÒS (ES); TANG, Yunqing, 08930 SANT ADRIÀ DEL BESÒS (ES)
(74) Representative: ZBM Patents - Zea, Barlocci & Markvardsen
(86) International application number: PCT/EP2022/066614
(87) International publication number: WO 2022/263659

(56) References cited:
- US-A1- 2008 149 911
- US-A1- 2009 122 465
- US-A1- 2018 358 552
- US-B1- 10 497 866
- KIDA T ET AL: "Planar-type BiCuVO"x solid electrolyte sensor for the detection of volatile organic compounds", SENSORS AND ACTUATORS B: CHEMICAL, ELSEVIER BV, NL, vol. 137, no. 1, 28 March 2009 (2009-03-28), pages 147 - 153, XP025962260, ISSN: 0925-4005, [retrieved on 20081214], DOI: 10.1016/J.SNB.2008.12.014

## Description

This application claims the benefit of European Patent Application 21382543.3 filed June 18, 2021.

The present disclosure relates to electronic transistors and to methods of forming electronic transistors.

### BACKGROUND

Metal Oxide Semiconductor Field Effect Transistor (MOSFET) is vastly used in electronics and computing industry. Complementary Metal Oxide Semiconductor (CMOS) is a type of MOSFET that uses complementary and symmetrical pairs of p-type and n-type MOSFETs for logic functions.

CMOS is used for construing integrated circuits comprising processors, microprocessors, microcontrollers, memory chips (e.g., CMOS BIOS), and other digital logic circuits. These integrated circuits based on CMOS technology are vastly used in computing electronics. As downscaling the size (in nm) of the CMOS transistors, computing performance is improved.

In addition, current computing performance is based on Von Neumann architecture and uses discrete information processing approaches and/or hierarchical storage. It is ideal for solving complex computational problems but limits computational performance efficiency due to Von Neumann bottleneck.

To that end, neuromorphic computing has been developed to realize human brain functionality as an alternative to the Von Neumann approach. This approach offers massively parallel and distributed computation that combines processing and memory with a very low power consumption.

As reaching CMOS scaling limits, other computing devices and technologies need to be developed to overcome CMOS low voltage, low power, and high-performance limitations.

As a result, Electrolyte-gated transistors (EGTs) have been developed. Electrolyte gating offers significant advantages for the realization of neuromorphic devices/architectures, including ultralow-voltage operation and the ability to form parallel-interconnected networks.

In addition, three-terminal devices have been developed that use an electrolyte gated transistor to control the resistance and/or conductance of a channel via injection or extraction of ions (e.g., H⁺, Ag⁺, Li⁺, Cu²⁺, O²⁻) that is triggered by a voltage applied at the gate electrode where the electrolyte (e.g., solid or liquid), contacting the gate with the channel, conducts ions. By modifying the resistance and/or the conductance of the channel that contacts a drain electrode with a source electrode, a switch may be obtained. However, the switching of these devices may be slow and/or lacking reversible multilevel switching.

Nevertheless, EGTs and/or three terminal devices that uses EGTs are difficult to integrate with solid-state devices (e.g., CMOS-based devices). EGTs and/or three terminal devices are temperature sensitive and/or unstable under humidity. In the case of Li-ion conductors, reported materials present a poor stability in ambient atmosphere and self-discharge issues hinder their real implementation in EGTs. In the case of EGTs based on oxygen conductors, the lack of room and/or low-temperature of oxideionic conductors forces an operation at non-viable elevated temperature (e.g., above 200°C).

In addition, these devices have poor/no compatibility with mainstream microelectronics fabrication processes (e.g., CMOS fabrication processes). CMOS fabrication processes permits scalability and well-known fabrication methods. Therefore, a need for EGTs that are compatible with CMOS fabrication process is needed.

US 2008 149 911 A1 relates to a programmable-resistance memory cell, a method of fabrication and a non-volatile memory device incorporating such a memory cell.

US 2018/358552 A1, US 2009/122465 A1, US 10 497 866 B1, and KIDA T ET AL: "Planar-type BiCuVOx solid electrolyte sensor for the detection of volatile organic compounds" relate to devices with an electrolyte.

Examples of the present disclosure seek to at least partially reduce one or more of the aforementioned problems.

### SUMMARY

According to a first aspect, an electronic transistor is provided. The transistor may comprise a body. The body may comprise at least an electrolyte structure; a channel provided in contact with the electrolyte structure; a gate provided in contact with the electrolyte structure. The transistor may comprise at least three contact elements configured to be connected to an external circuit. At least one of the contact elements, referenced as Gate contact element, may be separated from the electrolyte structure by means of the gate. The other contact elements, referenced as Source contact element and Drain contact element, may be interconnected by means of the channel and may be separated from the electrolyte structure also by means of the channel. The electrolyte structure may comprise an oxygen ion conducting electrolyte structure. The oxygen ion conducting electrolyte structure may comprise a BiMEVOX structure, where Bi is Bismuth, ME is a Metal, V is Vanadium and OX is an oxide.

The BiMEVOX structure used as an electrolyte structure provides some advantages to the electronic transistor, such as stability (BiMEVOX structure, as an oxide structure, can be used to expand the redox potential window and thereby widen the gate voltage range due to the excellent stability under large dc bias application), no dependency from external conditions (e.g., humidity, etc.) because oxide ions migrate via a vacancy mechanism or an interstitial mechanism, both of which are a bulk conduction mechanism needing no surface absorption; enhancement of manufacturing compatibility (compatible with mainstream microelectronic technology) or its performance at low temperatures (e.g. operation temperature at room temperature). This way, the BiMEVOX structure provides the benefits of oxides, while enables room temperature operation.

This last feature opens the door to a full new range of applications in microelectronic sector, such as neuromorphic computing and stochastic computing. In this electronic transistor, a gate bias is applied through the room temperature-electrolyte (BiMEVOX structure) to change the oxygen stoichiometry of the channel by pumping oxygen ions across. In such a way, the gate voltage "programmes" the conductance of the channel that, in the absence of gate bias, remains unaltered for very long times (~years) giving rise to a non-volatile multistate transistor. Moreover, the electronic transistor is compatible with microfabrication technologies.

In summary, the main distinctive features of said electronic transistors compared to existing EGTs are:
- it is fully based on oxide-ion conductors operating at a temperature below 200°C such as room temperature, which makes it temperature insensitive (at least up to 200°C) and stable under humidity;
- compatibility with semiconductor industry;
- lower voltage and power needed, and higher performance compared with current CMOS technology.

In some examples, the BiMEVOX structure may be configured to work in a temperature between 0°C and 200°C, for example, at room temperature.

In some examples, the metal ME may be selected from at least one of the following:
- Copper (BiCuVOX);
- Cobalt (BiCoVOX);
- Nickel (BiNiVOX);
- Magnesium (BiMgVOX).

For example, the BiCuVOX may be proposed due to its performance at low temperatures (i.e. between 0°C and 200°C).

In examples, the stoichiometry of the BiMEVOX structure is Bi₄V₂₋ₓMEₓO_{11-δ},
where 0<x<1 and 0<δ<1, for example, Bi₄V_{1.8}Cu_{0.2}O_{10.7}.

In some examples, the thickness of the BiMEVOX structure may be between 1 nm and 1 mm.

According to some examples, the channel may comprise a Mixed Ionic and Electronic Conductor (MIEC) oxide configured to vary its oxygen content, which supposes a consequent variation in its electronic conductivity.

In some examples, the gate may comprise a Mixed Ionic and Electronic Conductor (MIEC) oxide configured to vary its oxygen content, which supposes a consequent variation in its electronic conductivity.

In both cases, the Mixed Ionic and Electronic Conductor (MIEC) oxide may be selected from at least one of the following:
- a fluorite oxide;
- a Perovskites oxide;
- a Perovskite-derived structure.

In examples, the fluorite oxide may comprise Rare earth (Re) doped Ceria such as Ce₁₋ₓReₓO_{2-δ}, Re being selected from at least one of the following: Sm, Gd, Y, Pr, La.

In some examples, the Perovskites oxide may comprise La₁₋ₓSr₁₋ₓTmO_{3-δ}, the Transition metal (Tm) being selected from at least one of the following: Ti, V, Cr, Mn, Fe, Co, Cu, Ni, and 0<x<1, for example, the Perovskites oxide may comprise a MIEC La_{0.5}Sr_{0.5}FeO_{3-δ} (LSF), where 0<δ<0.5.

According to some examples, the Perovskite-derived structure may comprise a Ruddlesden-Popper phase La₁₋ₓSrₓTmO_{4+δ}, Tm being a Transition metal selected from at least one of the following: Mn, Cu, Ni, and 0<x<1.

In examples, the thickness of the channel is between 1 nm and 1 mm.

In examples, the thickness of the gate is between 1 nm and 1 mm.

In some examples, the material of each of the at least three contact elements may be selected from at least one of the following:
- a metal material;
- an electrically conductive polymer material;
- an electrically conductive ceramic material.

The material of the contact elements may be of high electrical conductivity, for example, with conductivity greater than 10³ S/cm.

In examples, the metal material may be selected from at least one of the following: Gold (Au); Nickel (Ni); Copper (Cu); Platinum (Pt); Palladium (Pd); any combination thereof.

According to some examples, the thickness of any of the at least three contact elements may be between 1 nm and 1 mm.

In some examples, the transistor may further comprise a seed between the Gate contact element and the gate and/or between at least one of the Source and the Drain contact elements, and the channel. The seed may be required to improve the adherence between a contact element and the channel. The seed may be the same or similar size of the contact element, occupying only the surface of the contact element.

According to another aspect, a method of forming an electronic transistor is provided. The method may comprise:
- depositing a channel;
- forming a first contact element, referenced as Source contact element, and a second contact element, referenced as Drain contact element, onto the channel;
- depositing an electrolyte structure, wherein the electrolyte structure comprises a BiMEVOX structure, where Bi is Bismuth, ME is a Metal, V is Vanadium and OX is an oxide;
- depositing a gate onto the electrolyte structure;
- forming at least a third contact element, referenced as Gate contact element, onto the gate.

It is important to note that the disclosed steps of the method may be executed in any suitable order to form an electronic transistor.

In some examples, depositing the channel and depositing the gate may comprise depositing the channel and the gate onto the same side of the deposited electrolyte structure, the channel and the gate being in contact with the electrolyte structure. This way, an in-plane configuration of an electronic transistor is obtained.

In some examples, depositing the electrolyte structure may comprise depositing the electrolyte structure onto the side of the deposited channel that is opposed to the side of the deposited channel in which the first contact element and the second contact element are formed, the channel being in contact with the electrolyte layer. In addition, depositing the gate onto the electrolyte structure may comprise depositing the gate onto the side of the electrolyte structure that is opposed to the side in which the electrolyte structure is in contact with the channel, the gate being in contact with the electrolyte structure. In this case, an out-of-plane configuration of an electronic transistor is obtained.

In some examples, the method may further comprise depositing a seed onto the channel before forming the first contact element and/or the second contact element, the seed being between the channel and the first contact element and/or the channel and the second contact element. One of the first and second contact elements or both of them may comprise the seed. The seed may be required to improve the adherence between a contact element and the channel. The seed may be the same or similar size of the contact element, occupying only the surface of the contact element.

In examples, the method may further comprise depositing a seed onto the gate before forming the third contact element, the seed being between the gate and the third contact element. The seed improve the adherence between the third contact element and the gate. The seed may be the same or similar size of the third contact element, occupying only the surface of the third contact element.

According to another aspect, a method of forming an electronic transistor is provided. The method may comprise:
- depositing an electrolyte structure, wherein the electrolyte structure comprises a BiMEVOX structure, where Bi is Bismuth, ME is a Metal, V is Vanadium and OX is an oxide;
- depositing a channel onto the deposited electrolyte structure;
- depositing a gate onto the electrolyte structure in the same side of the electrolyte structure in which the channel is deposited;
- forming a first contact element, referenced as Source contact element, and a second contact element, referenced as Drain contact element, onto the channel;
- forming at least a third contact element, referenced as Gate contact element, onto the gate.

This way, an in-plane configuration of an electronic transistor is obtained.

According to yet another aspect, a method of forming an electronic transistor is provided. The method may comprise:
- depositing a channel;
- forming a first contact element, referenced as Source contact element, and a second contact element, referenced as Drain contact element, onto the channel;
- depositing an electrolyte structure on top of the channel, wherein the electrolyte structure comprises a BiMEVOX structure, where Bi is Bismuth, ME is a Metal, V is Vanadium and OX is an oxide;
- depositing a gate on top of the electrolyte structure;
- forming at least a third contact element, referenced as Gate contact element, onto the gate.

This way, an out-of-plane configuration of an electronic transistor is obtained.

The term "structure" may be understood as a spatial pattern along 3 different directions (i.e. x, y, z) of a three-dimensional space which may be any suitable spatial arrangement such as, for example, a layer, a wafer, a cube, a cone, a cylinder, a disk, an hexagonal prism, a triangular prism, a pentagonal prism, a tetrahedron, an octahedron, a sphere and any combinations thereof.

The term "external medium" may be used to refer to the surroundings of the electronic transistor, e.g., the external environment and the external environment conditions.

The external environment conditions may comprise gas partial pressures (e.g., oxygen partial pressure); humidity conditions; and temperature.

The term "oxygen" may be used to refer to any allotrope of oxygen, e.g., O₁, O₂, O₃.

Thus, the term "oxygen ions" may be used to refer to any ion of any allotrope of oxygen, e.g., O⁻, O²⁻.

### BRIEF DESCRIPTION OF THE DRAWINGS

Non-limiting examples of the present disclosure will be described in the following, with reference to the appended drawings, in which:
Figure 1a and 1b respectively show an example of an electronic transistor in an in-plane and out-of-plane configuration according to the present disclosure;
Figure 2 illustrates a flow chart for operating switching operations of the electronic transistor according to an example of the present disclosure;
Figure 3 illustrates a flow chart of a method for forming an electronic transistor according to an example of the present disclosure.

### DETAILED DESCRIPTION OF EXAMPLES

In these figures the same reference signs have been used to designate matching elements.

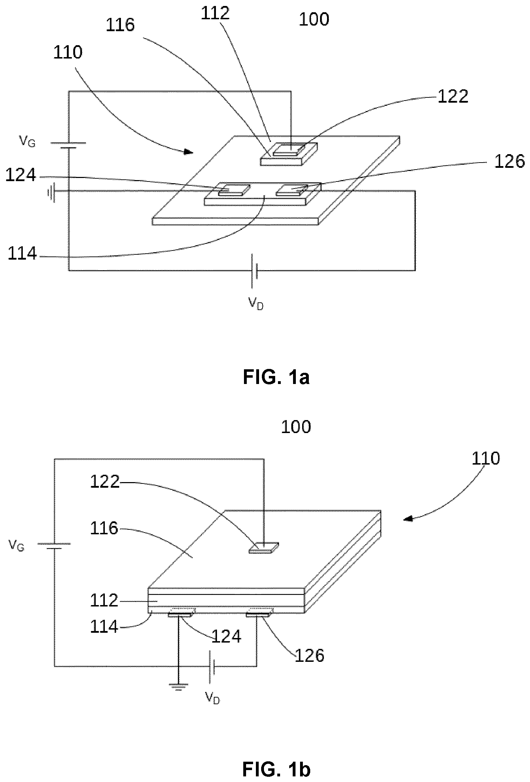

Figure 1a and 1b respectively show an example of an electronic transistor in an in-plane (Fig. 1a) and out-of-plane (Fig. 1b) configuration according to the present disclosure.

The electronic transistor 100 is a three-terminal device which may be an electrolyte-gated transistor (EGT). Electrolyte-gated transistors may offer significant advantages for the realization of neuromorphic devices/architectures, including ultralow-voltage operation and the ability to form parallel-interconnected networks.

An electronic transistor may be configured as a switch (i.e., switching operations comprising two different states that can be switched) or as an amplifier (i.e., when an input signal is amplified by the electronic transistor and an amplified output signal is obtained).

In Fig. 1a, the top side of an electrolyte structure 112 may contact a channel 114 at one end 115 of the electrolyte structure 112. Similarly, in Fig. 1b the bottom side of an electrolyte structure 112 may contact a channel 114.

In Fig. 1a and 1b, the electrolyte structure 112 is an oxygen ion conducting electrolyte structure. The oxygen ion conducting electrolyte structure may be solid or liquid. In this example, the electrolyte structure 112 is a solid oxygen ion conducting electrolyte structure and may have a thickness comprised between 1 nm and 1mm, specifically the thickness of the ion conducting electrolyte structure may be between 20 nm and 5 µm.

In some examples, the electrolyte structure 112 may comprise a BiMeVOX structure, where Bi is Bismuth, Me is a metal, V is Vanadium and OX is an oxide. It is noted that the BiMeVOX structure is a solid ion conducting electrolyte structure.

The BiMeVOX structure has a layered aurivillius structure which comprises alternating [Bi₂O₂]²⁺ and transition metal-doped perovskite [VO]²⁻ layers. The BiMeVOX structure may be used for ion (e.g., O²⁻) transport from an ion donor structure (i.e., a structure which may donate ions) to an ion receiver structure (i.e., a structure which may accept ions). Increasing disordered oxygen vacancies in the perovskite [VO]²⁻ layers may improve ion (e.g., O²⁻) mobility. In addition, ion (e.g., O²⁻) mobility may be maximized when the tetragonal γ-phase of the BiMeVOX structure is stabilized. Tetragonal γ-phase may be achieved at working temperatures above i.e., 550°C. Therefore, an ion conducting electrolyte structure with improved ion (e.g., O²⁻) conductivity may be obtained.

In addition, the tetragonal γ-phase of the BiMeVOX structure may be stabilized at lower working temperatures (i.e., below 550°C) by doping the vanadium with different metals (i.e., by cationic substitutions in vanadium positions). Therefore, the BiMeVOX structure may work in a temperature between 0°C and 200°C, and more specifically at room temperature (i.e., 20°C - 25°C).

The metal Me of the BiMeVOX structure may be selected from at least one of the following metals: copper (forming a BiCuVOX structure); cobalt (forming a BiCoVOX structure); nickel (forming a BiNiVOX structure); or magnesium (forming a BiMgVOX structure). Other metals may be used.

In addition, the stoichiometry of the BiMeVOX structure is Bi₄V₂₋ₓMₓO_{11-δ} where x is comprised between 0 < x< 1 and/or δ is comprised between 0 < δ < 1.

Specifically, as an example, the stoichiometry of the BiMeVOX structure may be Bi₄V_{1.8}Cu_{0.2}O_{10.7}.

In some examples, the electrolyte structure 112 may be deposited via conventional synthesis and deposition methods such as physical vapor deposition (PVD), for example, cathodic arc deposition, electron-beam physical vapor deposition, close-space sublimation, pulsed laser deposition; thermal evaporation; electron-beam evaporation; sputtering, for example, diode sputtering, RF diode sputtering, triode sputtering, magnetron sputtering, reactive sputtering, or ion-beam sputtering; ion-assisted deposition; chemical vapor deposition (CVD); sol-gel coatings; or atomic layer deposition (ALD).

Particularly, the electrolyte structure 112 may be deposited via pulsed laser deposition.

In this example (i.e., pulsed laser deposition), the electrolyte structure 112 may be deposited onto a substrate, for example, silicon, strontium titanate crystal SrTiO₃, polymers, metals, or ceramics. Alternatively, the substrate may comprise a strontium titanate crystal (SrTiO₃) layer with an underlying silicon layer. In addition, the substrate may be a substantially flat substrate and/or compatible with microelectronic fabrication. The thickness of the substrate may be between 50 nm and 1000 µm, specifically the thickness of the substrate may be between 100 nm and 300 nm.

In addition, a BiMeVOX structure such as Bi₄V₂₋ₓMₓO_{11-δ} (where x is comprised between 0 < x< 1 and/or δ is comprised between 0 < δ < 1), specifically a BiMeVOX structure such as Bi₄V_{1.8}Cu_{0.2}O_{10.7}, may be grown epitaxially on (001) oriented substrates.

On the one hand, the BiMeVOX structure may present an anisotropy in oxygen ion conduction. The BiMeVOX structure may provide a first oxygen ion conduction along the in-plane principal axis [010] and [100].

On the other hand, the BiMeVOX structure along [001] axis may provide a second oxygen ion conduction which is orders of magnitude lower than the first oxygen ion conduction. As a result, the conductivity of oxygen ions along [001] axis is lower than the conductivity of oxygen ions along the in-plane principal axis [010] and [100].

Therefore, the deposition of (001) oriented BiMeVOX structures may allow to promote oxygen vacancy migration and / or oxygen ion conduction from the channel 114 to a gate 116; and / or from the gate 116 to the channel 114.

Furthermore, the substrates may be selected in function of their lattice parameters to match the lattice parameter of the BiMeVOX structure, which may allow an epitaxial growth of the BiMeVOX structure. Consequently, BiMeVOX structures may be grown epitaxially onto a substrate via pulsed laser deposition with a deposition pressure which may be between 0.0067 mbar and 0.267 mbar, specifically the deposition pressure may be 0.267 mbar.

Consequently, ion conducting electrolyte structures, which may be stable at temperatures between 0°C and 200°C, and more specifically at room temperature (i.e. 20°C - 25°C), may be obtained. In addition, the ion conducting electrolyte structures may be compatible with CMOS fabrication processes.

As aforementioned before, the electrolyte structure 112 may contact the channel 114. The channel 114 may comprise a Mixed Ionic and Electronic Conductor (MIEC) oxide layer. MIECs layers may be selected from at least one of the following: fluorite oxides, for example, Rare earth (Re) doped Ceria Ce₁₋ₓReₓO_{2-δ} with rare earth (Re) such as samarium (Sm), gadolinium (Gd), yttrium (Y), praseodymium (Pr), lanthanum (La); perovskites oxides La₁₋ₓSr₁₋ₓTmO_{3-δ} with Tm transition metal such as titanium (Ti), vanadium (V), chromium (Cr), manganese (Mn), iron (Fe), cobalt (Co), copper (Cu), nickel (Ni) where x may be comprised between 0 < x< 1; or perovskite-derived structures such as Ruddlesden - Popper phase, for example, La₁₋ₓSrₓTmO_{4+δ} with Tm transition metal such as manganese (Mn), copper (Cu), nickel (Ni) where x may be comprised between 0 < x< 1. Specifically, the channel 114 may be a perovskite oxide with the stoichiometry La_{0.5}Sr_{0.5}FeO_{3-δ} (LSF), where δ may be comprised between 0 < δ < 0.5. Alternatively, MIECs layers may have an ABO₃ structure.

In addition, the channel 114 may have a thickness comprised between 1 nm and 1mm, specifically the thickness of the channel 114 may be between 20 nm and 5 µm.

In some examples, the channel 114 may be deposited via conventional synthesis and deposition methods such as physical vapor deposition (PVD) e.g. cathodic arc deposition, electron-beam physical vapor deposition, close-space sublimation, pulsed laser deposition; thermal evaporation; electron-beam evaporation; sputtering, for example, diode sputtering, RF diode sputtering, triode sputtering, magnetron sputtering, reactive sputtering, or ion-beam sputtering; ion-assisted deposition; chemical vapor deposition (CVD); sol-gel coatings; or atomic layer deposition (ALD).

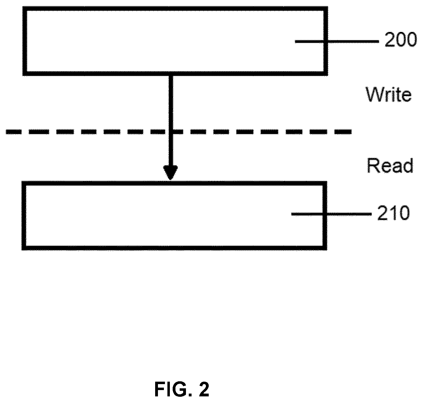

As will be described later on Figure 2, the oxygen content of the channel 114 may be varied, thereby decreasing or increasing the electronic conductivity of the channel such as the channel may be an insulator or a conductor depending on its oxygen content. Therefore, the channel 114 may be an ion donor structure (i.e., a structure which may donate ions) or an ion receiver structure (i.e., a structure which may accept ions).

Following the example, in Fig. 1a, the top side of the electrolyte structure 112 may contact the gate 116 at a second end 117 of the electrolyte structure 112. Similarly, in Fig. 1b, the top side of the electrolyte structure 112 may contact the gate 116. The gate 116 may comprise a Mixed Ionic and Electronic Conductor (MIEC) oxide layer. MIECs layers may be selected from at least one of the following: fluorite oxides, for example, Rare earth (Re) doped Ceria Ce₁₋ₓReₓO_{2-δ} with rare earth (Re) such as samarium (Sm), gadolinium (Gd), yttrium (Y), praseodymium (Pr), lanthanum (La); perovskites oxides La₁₋ₓSr₁₋ₓTmO_{3-δ} with Tm transition metal such as titanium (Ti), vanadium (V), chromium (Cr), manganese (Mn), iron (Fe), cobalt (Co), copper (Cu), nickel (Ni) where x may be comprised between 0 < x< 1; or perovskite-derived structures such as Ruddlesden - Popper phase, for example, La₁₋ₓSrₓTmO_{4+δ} with Tm transition metal such as manganese (Mn), copper (Cu), nickel (Ni) where x may be comprised between 0 < x< 1. Specifically, the gate 116 may be a perovskite oxide La₁₋ₓSr₁₋ₓTmO_{3-δ} with the stoichiometry La_{0.5}Sr_{0.5}FeO_{3-δ} (LSF), where δ may be comprised between 0 < δ < 0.5. Alternatively, MIECs layers may have an ABO₃ structure.

In addition, the gate 116 may have a thickness comprised between 1 nm and 1mm, specifically the thickness of the gate 116 may be between 20 nm and 5 µm.

In some examples, the gate 116 may be deposited via conventional synthesis and deposition methods such as physical vapor deposition (PVD), for example, cathodic arc deposition, electron-beam physical vapor deposition, close-space sublimation, pulsed laser deposition; thermal evaporation; electron-beam evaporation; sputtering e.g. diode sputtering, RF diode sputtering, triode sputtering, magnetron sputtering, reactive sputtering, or ion-beam sputtering; ion-assisted deposition; chemical vapor deposition (CVD); sol-gel coatings; or atomic layer deposition (ALD).

As will be described later on Figure 2, the oxygen content of the gate 116 may be varied, thereby decreasing or increasing the electronic conductivity of the channel such as the channel may be an insulator or a conductor depending on its oxygen content. Therefore, the gate 116 may be an ion donor structure (i.e., a structure which may donate ions) or an ion receiver structure (i.e., a structure which may accept ions).

In summary, the electronic transistor 100 illustrated in Fig. 1a and/or Fig. 1b is a three-terminal device which may be an electrolyte-gated transistor (EGT) and may include a body 110 comprising the electrolyte structure 112, the channel 114 and the gate 116. In addition, depending on the orientation and/or position of the channel 114 and the gate 116 with respect to the electrolyte structure 112, two different configurations of the electronic transistor 100 may be obtained.

Therefore, Fig. 1a may represent an in-plane configuration of the electronic transistor 100. In this example (i.e., Fig. 1a), the transport of ions (e.g., O₂-) may be pumped or transported across the electrolyte structure 112 where the channel 114 and the gate 116 may be at the same side (e.g., both on the top, or both on the bottom) of the electrolyte structure 112. Alternatively, Fig. 1b may represent an out-of-plane configuration of the electronic transistor 100. In this example (i.e., Fig. 1b), the transport of ions (e.g., O₂-) may be pumped or transported across the electrolyte structure 112 where the channel 114 and the gate 116 may be at opposite sides (e.g., on the top and on the bottom) of the electrolyte structure 112.

Again in Fig. 1a and Fig. 1b, the electronic transistor 100 may further comprise three contact elements. A Gate contact element 122 may be on the top of the electrolyte structure 112. Therefore, the gate contact element 122 may be separated from the electrolyte structure 112 by means of the gate 116. Similarly, a Source contact element 124 and a Drain contact element 126 may be on the opposite ends of the channel 114. Therefore, the source contact element 124 and the drain contact element 126 may be separated from the electrolyte structure 112 by means of the channel 114.

In some examples, a seed may be provided between the gate 116 and the gate contact element 122; and/or between the channel 114 and the source contact element 124; and/or between the channel 114 and the drain contact element 126. The seed may improve the adhesion of the contact elements (i.e., the gate contact element 122, the source contact element 124 and the drain contact element 126).

It is noted that adhesion may refer to the molecular attraction that holds the surfaces of two dissimilar substances together.

The seed may be of a material suitable to improve the adhesion of the contact elements such as metals, for example, copper (Cu), gold (Au), palladium (Pd), or any combination thereof.

The contact elements (i.e., the gate contact element 122, the source contact element 124 and the drain contact element 126) may be of a material suitable for conducting electric charges (e.g., a material with an electrical conductivity above 10³ S/cm) such as metals, for example, platinum (Pt), gold (Au), nickel (Ni), copper (Cu), palladium (Pd), or any combination thereof; electrically conductive polymers; or electrically conductive ceramics.

In addition, the contact elements may have a thickness comprised between 1 nm and 1mm. More specifically, the thickness of the contact elements may be between 20 nm and 5 µm. The same thickness for all contact elements is not required.

The contact elements and/or the seed may be deposited via conventional synthesis and deposition methods such as physical vapor deposition PVD (e.g. cathodic arc deposition, electron-beam physical vapor deposition, close-space sublimation, pulsed laser deposition); thermal evaporation; electron-beam evaporation; sputtering (e.g. diode sputtering, RF diode sputtering, triode sputtering, magnetron sputtering, reactive sputtering, or ion-beam sputtering); ion-assisted deposition; chemical vapor deposition CVD; sol-gel coatings; or atomic layer deposition ALD.

In addition, the source contact element 124 and the drain contact element 126 may establish electrical contact with channel 114. Similarly, the gate contact element 122 may establish electrical contact with the gate 116.

In some examples, a capping layer may be configured to be onto the channel 114 and / or the gate 116.

In some of these examples, the capping layer may be configured to be additionally onto the electrolyte structure 112, and / or the gate contact element 122; and / or the source contact element 124; and / or the drain contact element 126.

In these examples, the capping layer may be of a material suitable for insulating oxygen ions, e.g., alumina Al₂O₃ or magnesium oxide MgO. As a result, the capping layer may prevent leakage of oxygen ions from the electronic transistor 100 (e.g., from the channel 114, from the gate 116) to an external medium; and / or inclusion of oxygen from the external medium to the electronic transistor 100 (e.g., to the channel 114, to the gate 116).

In addition, the capping layer may comprise a thickness between 1 nm and 500 nm, specifically between 1 nm and 100 nm.

The capping layer may be deposited via conventional synthesis and deposition methods such as physical vapor deposition PVD (e.g. cathodic arc deposition, electron-beam physical vapor deposition, close-space sublimation, pulsed laser deposition); thermal evaporation; electron-beam evaporation; sputtering (e.g. diode sputtering, RF diode sputtering, triode sputtering, magnetron sputtering, reactive sputtering, or ion-beam sputtering); ion-assisted deposition; chemical vapor deposition CVD; sol-gel coatings; or atomic layer deposition ALD.

In some examples, the capping layer may be deposited via atomic layer deposition ALD comprising a deposition chamber. In these examples, an aluminum precursor (e.g., metal alkyl trimethylaluminium TMA) may be chosen for alumina Al₂O₃ deposition. Each ALD cycle may comprise:
- a first step with a duration of 0.1 second comprising a pulse of TMA;
- a second step with a duration of 6 seconds comprising a purge of the deposition chamber with nitrogen gas;
- a third step with a duration of 0.1 second comprising a pulse of water on the electronic transistor 100; and
- a fourth step with a duration of 6 seconds comprising a purge of the deposition chamber with nitrogen gas.

ALD cycles may be repeated to obtain a capping layer thickness of between 1 nm and 500 nm, specifically between 1 nm and 100 nm; and more specifically 100 nm. During the ALD cycles, the deposition chamber may be kept at 300°C.

Figure 2 illustrates a flow chart for operating switching operations of the electronic transistor. In Fig. 2, the operation of the electronic transistor 100 is described. In this example, switching operations may be performed between two different states that can be switched.

At block 200, a write voltage pulse may be applied at the gate contact element 122 through an external electrical circuit. As hereinbefore described in Fig. 1, the gate 116 may contact the electrolyte structure 112. Therefore, when a write voltage pulse is applied at the gate contact element 122, the electrolyte structure 112 contacting the gate 116 that is in electrical contact with the gate contact element 122, may transport and/or pump ions (e.g., O₂-) from an ion donor structure (i.e., a structure which may donate ions) to an ion receiver structure (i.e., a structure which may accept ions).

When a positive write voltage pulse is applied at the gate contact element 122, ions (e.g., O₂-) may be transported across the electrolyte structure 112 from the gate 116 (i.e., the ion donor structure) to the channel 114 (i.e., the ion receiver structure). By injecting ions (e.g., O₂-) to the channel 114, the oxygen content of the channel 114 may be varied (i.e., increased). It is noted that the oxygen content of the channel 114 may vary the conductance of the channel 114 due to the ion gating effect. Consequently, the electrical conductivity of the channel may be inherently varied because of the variation of the conductance of the channel. Thereby, the electrical conductivity of the channel may be changed such as the channel 114 may be switched from an insulator state to a conductor state.

A negative write voltage pulse may serve to return the channel to its as-fabricated, insulator state, thereby permitting writing and re-writing operations to be performed. When a negative write voltage pulse is applied at the gate contact element 122, ions (e.g., O₂-) may be transported across the electrolyte structure 112 from the channel 114 (i.e., the donor ion structure) to the gate 116 (i.e., the receiver ion structure). Therefore, ions (e.g., O₂-) may be extracted from the channel 114 to the gate 116. Consequently, the oxygen content of the channel 114 may be varied (i.e., decreased). Thereby, the electrical conductivity of the channel may be changed such as the channel 114 may be switched from a conductor state to an insulator state. Thus, applying a negative write voltage pulse may restore the conductance of the channel 114 to its original state (prior to application of the positive write voltage pulse).

Additionally, depending on the voltage applied at the gate (i.e. the write voltage pulse), a plurality of intermediate channel states may be obtained between a first channel state where the conductance of the channel may correspond to an insulator state and a second channel state where the conductance of the channel may correspond to a conductor state. The conductance of the channel of each channel state of the plurality of intermediate channel states may be comprised between the conductance of the channel of the first channel state and the conductance of the channel of the second channel state. Therefore, a multilevel switching may be obtained between e.g. the first channel state and each channel state of the plurality of intermediate channel states; and/or between each channel state of the plurality of intermediate channel states and the second channel state. Consequently, the electronic transistor 100 may comprise a plurality of states (e.g. corresponding to the first channel state, the plurality of intermediate channel states, and/or the second channel state). Hence, the electronic transistor 100 may correspond to a plurality of CMOS transistors that may have only one state.

Consequently, an electronic transistor 100 configured to perform reversible and non-volatile write operations may be operated by applying a write voltage pulse (e.g. positive or negative) at the gate contact element 122.

At block 210, a read operation may be performed by the electronic transistor 100. The conductance of the channel may be read between the source contact element 124 and the drain contact element 126. Conductance switching may occur as ions (e.g., O₂-) are reversibly injected or extracted in and out of the channel 114 when a write voltage pulse is applied at the gate contact element 122.

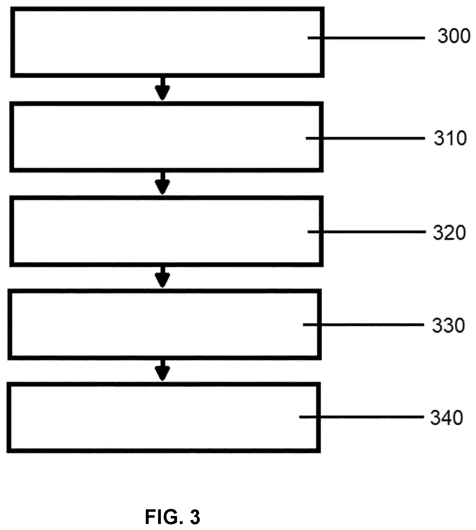

Figure 3 illustrates a flow chart of a method for forming an electronic transistor 100.

At block 300, a channel may be deposited via conventional synthesis and deposition methods.

At block 310, a first contact element (i.e., source contact element) and a second contact element (i.e., drain contact element) may be deposited on the opposite ends of the channel via conventional synthesis and deposition methods.

At block 320, an electrolyte structure may be deposited on the side of the channel that is opposed to the side of the channel in which the first contact element and the second contact element are formed (e.g., the electrolyte structure may be on the bottom side of the channel whereas the first contact element and the second contact element may be on the top side of the channel) via conventional synthesis and deposition methods.

At block 330, a gate may be deposited on the electrolyte structure via conventional synthesis and deposition methods.

In some examples, the gate may be deposited on the side of the electrolyte structure that is opposed to the side of the electrolyte structure in which the channel is deposited (e.g., the gate may be on the bottom side of the electrolyte structure whereas the channel may be on the top side of the electrolyte structure).

Alternatively, the gate may be deposited on the side of the electrolyte structure in which the channel is deposited (e.g., the gate may be on the top side of the electrolyte structure and the channel may be on the top side of the electrolyte structure; or the gate may be on the bottom side of the electrolyte structure and the channel may be on the bottom side of the electrolyte structure).

At block 340, a third contact element (i.e., gate contact element) may be deposited on the gate via conventional synthesis and deposition methods.

In some examples, the method of forming an electronic transistor may further comprise depositing a seed on the channel before forming the first contact element and/or the second contact element, the seed being between the channel and the first contact element and/or the channel and the second contact element. The seed may be deposited via conventional synthesis and deposition methods.

In some examples, the method of forming an electronic transistor may further comprise depositing a capping layer arranged on the electronic transistor. Specifically, the capping layer may be configured to be onto the channel and / or the gate.

In some of these examples, the capping layer may be configured to be additionally onto the electrolyte, and / or the gate contact element; and / or the source contact element; and / or the drain contact element.

It is noted that conventional synthesis and deposition methods may comprise physical vapor deposition (PVD), for example, cathodic arc deposition, electron-beam physical vapor deposition, close-space sublimation, pulsed laser deposition; thermal evaporation; electron-beam evaporation; sputtering e.g. diode sputtering, RF diode sputtering, triode sputtering, magnetron sputtering, reactive sputtering, or ion-beam sputtering; ion-assisted deposition; chemical vapor deposition (CVD); sol-gel coatings; or atomic layer deposition (ALD).

Consequently, an electronic transistor 100, which may be compatible with CMOS fabrication processes, may be formed.

## Claims

1. An electronic transistor (100) comprising:
- a body comprising at least:
∘ an electrolyte structure (112);
∘ a channel (114) provided in contact with the electrolyte structure (112);
∘ a gate (116) provided in contact with the electrolyte structure (112);
- at least three contact elements configured to be connected to an external circuit, at least one of the contact elements, referenced as Gate contact element, being separated from the electrolyte structure (112) by means of the gate (116), and the other contact elements, referenced as Source contact element and Drain contact element, being interconnected and being separated from the electrolyte structure (112) by means of the channel (114);
**characterized in that** the electrolyte structure (112) comprises an oxygen ion conducting electrolyte structure (112), wherein the oxygen ion conducting electrolyte structure (112) comprises a BiMEVOX structure, where Bi is Bismuth, ME is a Metal, V is Vanadium and OX is an Oxide; wherein the stoichiometry of the BiMEVOX structure is Bi₄V₂₋ₓMEₓO_{11-δ}, where 0<x<1 and 0<δ<1.

2. The transistor (100) according to claim 1, wherein the metal ME of the BiMEVOX structure is selected from at least one of the following:
- Copper (BiCuVOX);
- Cobalt (BiCoVOX);
- Nickel (BiNiVOX);
- Magnesium (BiMgVOX).

3. The transistor (100) according to any of claims 1 or 2, wherein the BiMEVOX structure is configured to work in a temperature between 0°C and 200°C.

4. The transistor (100) according to any of claims 1 to 3, wherein the channel (114) comprises a Mixed Ionic and Electronic Conductor (MIEC) oxide configured to vary its oxygen content, which supposes a consequent variation in its electronic conductivity.

5. The transistor (100) according to any of claims 1 to 4, wherein the gate (116) comprises a Mixed Ionic and Electronic Conductor (MIEC) oxide configured to vary its oxygen content, which supposes a consequent variation in its electronic conductivity.

6. The transistor (100) according to any of claims 4 or 5, wherein the Mixed Ionic and Electronic Conductor (MIEC) oxide is selected from at least one of the following:
- a fluorite oxide;
- a Perovskites oxide;
- a Perovskite-derived structure.

7. The transistor (100) according to claim 6, wherein the fluorite oxide comprises Rare earth (Re) doped Ceria such as Ce₁₋ₓReₓO_{2-δ}, Re being selected from at least one of the following: Sm, Gd, Y, Pr, La.

8. The transistor (100) according to any of claims 6 or 7, wherein the Perovskites oxide comprises La₁₋ₓSr₁₋ₓTmO_{3-δ}, the Transition metal (Tm) being selected from at least one of the following: Ti, V, Cr, Mn, Fe, Co, Cu, Ni, and 0<x<1, such as a MIEC La_{0.5}Sr_{0.5}FeO_{3-δ} (LSF), where 0<δ<0.5.

9. The transistor (100) according to any of claims 6 to 8, wherein the Perovskite-derived structure comprises a Ruddlesden-Popper phase La₁₋ₓSrₓTmO_{4+δ}, Tm being a Transition metal selected from at least one of the following: Mn, Cu, Ni, and 0<x<1.

10. The transistor (100) according to any of claims 1 to 9, wherein the material of each of the at least three contact elements is selected from at least one of the following:
- a metal material;
- an electrically conductive polymer material;
- an electrically conductive ceramic material.

11. A method of forming an electronic transistor (100), the method comprising:
- depositing a channel (114);
- forming a first contact element, referenced as Source contact element, and a second contact element, referenced as Drain contact element, onto the channel (114);
- depositing an electrolyte structure (112), wherein the electrolyte structure (112) comprises a BiMEVOX structure, where Bi is Bismuth, ME is a Metal, V is Vanadium and OX is an Oxide wherein the stoichiometry of the BiMEVOX structure is Bi₄V₂₋ₓMEₓO_{11-δ}, where 0<x<1 and 0<δ<1;
- depositing a gate (116) onto the electrolyte structure (112);
- forming at least a third contact element, referenced as Gate contact element, onto the gate (116).

12. The method according to claim 11, wherein depositing the channel (114) and depositing the gate (116) comprise:
- depositing the channel (114) and the gate (116) onto the same side of the deposited electrolyte structure (112), the channel (114) and the gate (116) being in contact with the electrolyte structure (112).

13. The method according to claim 11, wherein depositing the electrolyte structure (112) comprises:
- depositing the electrolyte structure (112) onto the side of the deposited channel (114) that is opposed to the side of the deposited channel (114) in which the first contact element and the second contact element are formed, the channel (114) being in contact with the electrolyte structure (112);
wherein depositing the gate (116) onto the electrolyte structure (112) comprises:
- depositing the gate (116) onto the side of the electrolyte structure (112) that is opposed to the side in which the electrolyte structure (112) is in contact with the channel (114), the gate (116) being in contact with the electrolyte structure (112).

14. The method according to any of claims 11 to 13, further comprising:
- depositing a seed onto the channel (114) before forming the first contact element and/or the second contact element, the seed being between the channel (114) and the first contact element and/or the channel (114) and the second contact element.

15. The method according to any of claims 11 to 14, further comprising:
- depositing a seed onto the gate (116) before forming the third contact element, the seed being between the gate (116) and the third contact element.

## Patentansprüche

1. Ein elektronischer Transistor (100), umfassend:
- einen Körper, umfassend mindestens:
∘ eine Elektrolytstruktur (112);
∘ einen Kanal (114), der in Kontakt mit der Elektrolytstruktur (112) bereitgestellt ist;
∘ ein Gate (116), das in Kontakt mit der Elektrolytstruktur (112) bereitgestellt ist;
- mindestens drei Kontaktelemente, die konfiguriert sind, um mit einem externen Schaltkreis verbunden zu werden, wobei mindestens eines der Kontaktelemente, das als Gate-Kontaktelement bezeichnet wird, durch das Gate (116) von der Elektrolytstruktur (112) getrennt ist und die anderen Kontaktelemente, die als Source-Kontaktelement und Drain-Kontaktelement bezeichnet werden, miteinander verbunden sind und durch den Kanal (114) von der Elektrolytstruktur (112) getrennt sind;
**dadurch gekennzeichnet, dass** die Elektrolytstruktur (112) eine Sauerstoffionen leitende Elektrolytstruktur (112) umfasst, wobei die Sauerstoffionen leitende Elektrolytstruktur (112) eine BiMEVOX-Struktur umfasst, wobei Bi Bismut ist, ME ein Metall ist, V Vanadium ist und OX ein Oxid ist; wobei die Stöchiometrie der BiMEVOX-Struktur BiN2-xMExO11-o ist, wobei 0<x<1 und 0<8<1 ist.

2. Der Transistor (100) nach Anspruch 1, wobei das Metall ME der BiMEVOX-Struktur aus mindestens einem der folgenden ausgewählt ist:
- Kupfer (BiCuVOX);
- Kobalt (BiCoVOX);
- Nickel (BiNiVOX);
- Magnesium (BiMgVOX).

3. Der Transistor (100) nach einem der Ansprüche 1 oder 2, wobei die BiMEVOX-Struktur dazu konfiguriert ist, bei einer Temperatur zwischen 0 °C und 200 °C zu arbeiten.

4. Der Transistor (100) nach einem der Ansprüche 1 bis 3, wobei der Kanal (114) ein Mischleiter-Oxid (auf Englisch *MIEC oxide* - MIEC: *mixed ionic and electronic conductor*) umfasst, das dazu konfiguriert ist, seinen Sauerstoffgehalt zu variieren, was eine konsequente Variation seiner elektronischen Leitfähigkeit voraussetzt.

5. Der Transistor (100) nach einem der Ansprüche 1 bis 4, wobei das Gate (116) ein Mischleiter-Oxid umfasst, das dazu konfiguriert ist, seinen Sauerstoffgehalt zu variieren, was eine konsequente Variation seiner elektronischen Leitfähigkeit voraussetzt.

6. Der Transistor (100) nach einem der Ansprüche 4 oder 5, wobei das Mischleiter-Oxid aus mindestens einem der folgenden ausgewählt ist:
- einem Fluoritoxid;
- einem Perowskitenoxid;
- einer von Perowskit abgeleiteten Struktur.

7. Der Transistor (100) nach Anspruch 6, wobei das Fluoritoxid mit Re (englisch für *rare earth,* seltene Erdelemente) dotiertes Cerdioxid, wie etwa Ce1-xRexO2-o, umfasst, wobei Re aus mindestens einem der folgenden ausgewählt ist: Sm, Gd, Y, Pr, La.

8. Der Transistor (100) nach einem der Ansprüche 6 oder 7, wobei das Perowskitenoxid La1-xSr1-xTmO3-o umfasst, wobei das Übergangsmetall (Tm, englisch: *transition metal*) aus mindestens einem der folgenden ausgewählt ist: Ti, V, Cr, Mn, Fe, Co, Cu, Ni und 0<x<1, wie z.B. ein Mischleiter-Oxid wie folgt: Lao.sSro.sFeO3-o (LSF), wobei 0<o<0,5.

9. Der Transistor (100) nach einem der Ansprüche 6 bis 8, wobei die von Perowskit abgeleitete Struktur eine Ruddlesden-Popper-Phase-La1-xSrxTmO4+o umfasst, wobei Tm ein Übergangsmetall ist, das aus mindestens einem der folgenden ausgewählt ist: Mn, Cu, Ni, mit 0<x<1.

10. Der Transistor (100) nach einem der Ansprüche 1 bis 9, wobei das Material von jedem der mindestens drei Kontaktelemente aus mindestens einem der folgenden ausgewählt ist:
- einem Metallmaterial;
- einem elektrisch leitfähigen Polymermaterial;
- einem elektrisch leitfähigen Keramikmaterial.

11. Ein Verfahren zum Bilden eines elektronischen Transistors (100), wobei das Verfahren Folgendes umfasst:
- abscheiden eines Kanals (114);
- bilden eines ersten Kontaktelements, das als Source-Kontaktelement bezeichnet wird, und eines zweiten Kontaktelements, das als Drain-Kontaktelement bezeichnet wird, auf dem Kanal (114);
- abscheiden einer Elektrolytstruktur (112), wobei die Elektrolytstruktur (112)
- eine BiMEVOX-Struktur umfasst, wobei Bi Bismut ist, ME ein Metall ist, V Vanadium ist und OX ein Oxid ist,
- wobei die Stöchiometrie der BiMEVOX-Struktur BiN2-xMExO11-o ist, wobei 0<x<1 und 0<8<1;
- abscheiden eines Gates (116) auf der Elektrolytstruktur (112);
- bilden von mindestens einem dritten Kontaktelement, das als Gate-Kontaktelement bezeichnet wird, auf dem Gate (116).

12. Das Verfahren nach Anspruch 11, wobei das Abscheiden des Kanals (114) und das Abscheiden des Gates (116) Folgendes umfassen:
- abscheiden des Kanals (114) und des Gates (116) auf der gleichen Seite der abgeschiedenen Elektrolytstruktur (112), wobei der Kanal (114) und das Gate (116) in Kontakt mit der Elektrolytstruktur (112) sind.

13. Das Verfahren nach Anspruch 11, wobei das Abscheiden der Elektrolytstruktur (112) Folgendes umfasst:
- abscheiden der Elektrolytstruktur (112) auf der Seite des abgeschiedenen Kanals (114), die der Seite des abgeschiedenen Kanals (114) gegenüberliegt, in der das erste Kontaktelement und das zweite Kontaktelement gebildet sind, wobei der Kanal (114) in Kontakt mit der Elektrolytstruktur (112) ist;
wobei das Abscheiden des Gates (116) auf der Elektrolytstruktur (112) Folgendes umfasst:
- abscheiden des Gates (116) auf der Seite der Elektrolytstruktur (112), die der Seite gegenüberliegt, in der die Elektrolytstruktur (112) in Kontakt mit dem Kanal (114) ist, wobei das Gate (116) in Kontakt mit der Elektrolytstruktur (112) ist.

14. Das Verfahren nach einem der Ansprüche 11 bis 13, weiterhin umfassend:
- abscheiden eines Keims auf dem Kanal (114) vor dem Bilden des ersten Kontaktelements und/oder des zweiten Kontaktelements, wobei sich der Keim zwischen dem Kanal (114) und dem ersten Kontaktelement und/oder dem Kanal (114) und dem zweiten Kontaktelement befindet.

15. Das Verfahren nach einem der Ansprüche 11 bis 14, weiterhin umfassend:
- abscheiden eines Keims auf dem Gate (116), bevor das dritte Kontaktelement gebildet wird, wobei sich der Keim zwischen dem Gate (116) und dem dritten Kontaktelement befindet.

## Revendications

1. Un transistor électronique (100) comprenant :
- un corps comprenant au moins :
∘ une structure d'électrolyte (112) ;
∘ un canal (114) prévu en contact avec la structure d'électrolyte (112) ;
∘ une grille (116) prévue en contact avec la structure d'électrolyte (112) ;
- au moins trois éléments de contact configurés de manière à être connectés à un circuit externe, au moins l'un des éléments de contact, référencé comme élément de contact de grille, étant séparé de la structure d'électrolyte (112) au moyen de la grille (116), et les autres éléments de contact, référencés comme élément de contact de source et élément de contact de drain, étant interconnectés et étant séparés de la structure d'électrolyte (112) au moyen du canal (114) ;
**caractérisé en ce que** la structure d'électrolyte (112) comprend une structure d'électrolyte conductrice d'ions d'oxygène (112), dans lequel la structure d'électrolyte conductrice d'ions d'oxygène (112) comprend une structure BiMEVOX, où Bi est le Bismuth, ME est un Métal, V est le Vanadium et OX est un Oxyde ; dans lequel la stoechiométrie de la structure BiMEVOX est BiN2-xMExO11-o, où 0<x<1 et 0<8<1.

2. Le transistor (100) selon la revendication 1, dans lequel le métal ME de la structure BiMEVOX est choisi parmi au moins l'un des suivants :
- Cuivre (BiCuVOX) ;
- Cobalt (BiCoVOX) ;
- Nickel (BiNiVOX) ;
- Magnésium (BiMgVOX).

3. Le transistor (100) selon l'une quelconque des revendications 1 ou 2, dans lequel la structure BiMEVOX est configurée pour fonctionner à une température comprise entre 0°C et 200°C.

4. Le transistor (100) selon l'une quelconque des revendications 1 à 3, dans lequel le canal (114) comprend un oxyde mixte à la fois conducteur électronique et conducteur ionique (en anglais *MIEC oxide,* MIEC étant *mixed ionic and electronic conductor*) configuré pour faire varier sa teneur en oxygène, ce qui suppose une variation conséquente de sa conductivité électronique.

5. Le transistor (100) selon l'une quelconque des revendications 1 à 4, dans lequel la grille (116) comprend un oxyde mixte conducteur électronique et conducteur ionique configuré pour faire varier sa teneur en oxygène, ce qui suppose une variation conséquente de sa conductivité électronique.

6. Le transistor (100) selon l'une quelconque des revendications 4 ou 5, dans lequel l'oxyde mixte conducteur électronique et conducteur ionique est choisi parmi au moins l'un des suivants :
- un oxyde de fluorite ;
- a oxyde de pérovskites ;
- une structure dérivée de la pérovskite.

7. Le transistor (100) selon la revendication 6, dans lequel l'oxyde de fluorite comprend de la céria dopée à la terre rare (Re, *rare earth*) telle que Ce1-xRexO2-o, Re étant sélectionnée parmi au moins l'un des éléments suivants : Sm, Gd, Y, Pr, La.

8. Le transistor (100) selon l'une quelconque des revendications 6 ou 7, dans lequel l'oxyde de pérovskites comprend La1-xSr1-xTmO3-o, le métal de transition (Tm, *transition metal*) étant choisi parmi au moins l'un des éléments suivants : Ti, V, Cr, Mn, Fe, Co, Cu, Ni et 0<x<1, tels qu'un oxyde mixte conducteur électronique et conducteur ionique du type : Lao.sSro.sFeO3-o (LSF), où 0<o<0,5.

9. Le transistor (100) selon l'une quelconque des revendications 6 à 8, dans lequel la structure dérivée de la pérovskite comprend un La1-xSrxTmO4+o de phase Ruddlesden-Popper, Tm étant un métal de transition choisi parmi au moins l'un des éléments suivants : Mn, Cu, Ni, et 0<x<1.

10. Le transistor (100) selon l'une quelconque des revendications 1 à 9, dans lequel le matériau de chacun des au moins trois éléments de contact est sélectionné parmi au moins l'un des suivants :
- un matériau métallique ;
- un matériau polymère électriquement conducteur ;
- un matériau céramique électriquement conducteur.

11. Un procédé de formation d'un transistor électronique (100), le procédé comprenant:
- déposer un canal (114) ;
- former un premier élément de contact, référencé comme élément de contact de source, et un second élément de contact, référencé comme élément de contact de drain, sur le canal (114) ;
- déposer une structure d'électrolyte (112), dans lequel la structure d'électrolyte (112)
- comprend une structure BiMEVOX, où Bi est le Bismuth, ME est un métal, V est le Vanadium et OX est un oxyde,
- dans lequel la stœchiométrie de la structure BiMEVOX est BiN2-xMExO11-o, où 0<x<1 et 0<8<1 ;
- déposer une grille (116) sur la structure d'électrolyte (112) ;
- former au moins un troisième élément de contact, référencé comme élément de contact de grille, sur la grille (116).

12. Le procédé selon la revendication 11, dans lequel déposer le canal (114) et déposer la grille (116) comprennent :
- déposer le canal (114) et la grille (116) sur le même côté de la structure d'électrolyte déposée (112), le canal (114) et la grille (116) étant en contact avec la structure d'électrolyte (112).

13. Le procédé selon la revendication 11, dans lequel déposer la structure d'électrolyte (112) comprend :
- déposer la structure d'électrolyte (112) sur le côté du canal déposé (114) qui est opposé au côté du canal déposé (114) dans lequel le premier élément de contact et le second élément de contact sont formés, le canal (114) étant en contact avec la structure d'électrolyte (112) ;
dans lequel déposer la grille (116) sur la structure d'électrolyte (112) comprend :
- déposer la grille (116) sur le côté de la structure d'électrolyte (112) qui est opposé au côté dans lequel la structure d'électrolyte (112) est en contact avec le canal (114), la grille (116) étant en contact avec la structure d'électrolyte (112).

14. Le procédé selon l'une quelconque des revendications 11 à 13, comprenant en outre :
- déposer un germe sur le canal (114) avant de former le premier élément de contact et/ou le second élément de contact, le germe étant entre le canal (114) et le premier élément de contact et/ou le canal (114) et le second élément de contact.

15. Le procédé selon l'une quelconque des revendications 11 à 14, comprenant en outre :
- déposer un germe sur la grille (116) avant de former le troisième élément de contact, le germe étant entre la grille (116) et le troisième élément de contact.
